Europäisches Patentamt

European Patent Office

Office européen des brevets

(11) Publication number: **0 154 765 B1**

# EUROPEAN PATENT SPECIFICATION

(45) Date of publication of patent specification: **29.04.92**   (51) Int. Cl.5: **G06F 1/00**, H05K 1/14

(21) Application number: **85100003.4**

(22) Date of filing: **02.01.85**

(54) **Apparatus for directly powering a multi-chip module from a power distribution bus.**

(30) Priority: **12.03.84 US 588610**

(43) Date of publication of application:
**18.09.85 Bulletin 85/38**

(45) Publication of the grant of the patent:
**29.04.92 Bulletin 92/18**

(84) Designated Contracting States:
**DE FR GB**

(56) References cited:
DE-B- 1 790 126
US-A- 3 519 959
US-A- 4 315 315

**IBM TECHNICAL DISCLOSURE BULLETIN, vol. 26, no. 4, September 1983, page 1853-1854, New York, US; B.L. HENLEY et al.: "Power supply construction for use on printed circuit boards"**

(73) Proprietor: **International Business Machines Corporation**
**Old Orchard Road**
**Armonk, N.Y. 10504(US)**

(72) Inventor: **Balderes, Demetrios**
**30 Highview Road**
**Wappingers Falls, NY 12590(US)**
Inventor: **Frankovsky, Andrew J.**
**2913 Ricky Drive**
**Endwell, NY 13760(US)**
Inventor: **Jarvela, Robert A.**
**12 Maloney Drive**
**Wappingers Falls, NY 12590(US)**

(74) Representative: **Gaugel, Heinz, Dipl.-Ing.**
**IBM Deutschland GmbH Schönaicher Strasse 220**
**W-7030 Böblingen(DE)**

## Description

### Background of the Invention

### Field of the Invention

The present invention pertains to printed circuit board packaging technology, and, more particularly, to a method and apparatus for powering a module, mounted on the printed circuit board, directly from a power distribution bus rather than powering the module from the power distribution bus by way of the printed circuit board.

### Description of the Prior Art

The computers of the future will require a high throughput performance. High performance is measured in terms of cycle time and the number of cycles per instruction. However, in order to achieve this high performance, the number of circuits on an integrated circuit chip must increase. Further, the number of integrated circuit chips must also increase. The introduction of high density integrated circuit packages, such as a Thermal Conduction Module, has provided for the increased number of integrated circuit chips necessary to produce the required high performance.

However, with the introduction of these high density integrated circuit packages, two undesirable side effects are noticeable: (1) the power dissipated by a package is higher than previously experienced, and (2) the required current supplied to the package has increased significantly. These high circuit density integrated circuit packages necessitate the use of a large number of input/output (non-signal) pins to power the chips and to maintain power losses and voltage drops at reasonable levels. This requirement for more pins is compounded by the simultaneous demand for an increased number of input/output signal pins required to conduct the necessary signals to or from the increased number of circuits on the chips.

Furthermore, the demand for an increased number of circuits renders difficult the design of a modular or granular system. If a system is highly modular or granular in nature, it is easy to maintain and service by field representatives.

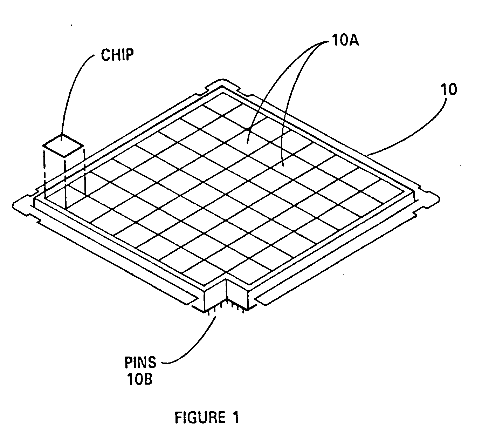

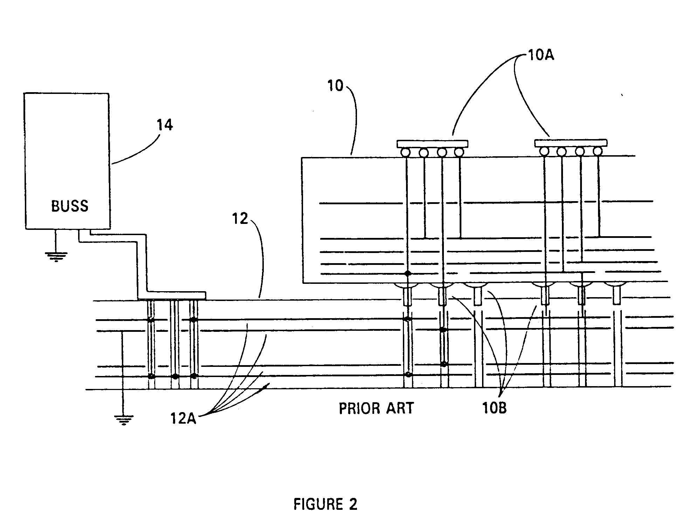

In prior art printed circuit board packaging system designs, a module, such as module 10 shown in FIG. 1, has a plurality of integrated circuit chips 10a mounted thereon. Referring to FIG. 2, the module 10 is mounted on a printed circuit board 12, the module being connected to various power distribution planes 12a within the board. The planes 12a are connected to a power distribution bus 14 thereby carrying the required current and providing the required voltage to the module 10 as necessary to power the chips 10a mounted on the module. The module 10 includes a multitude of input/output pins 10b connected to the power distribution planes 12a in the printed circuit board 12 for conducting the voltage and current to the chips 10 a. A comparable system for powering electronic components mounted on component boards, which are themselves mounted on a laminated electrical distribution board, is described in US-A-3 519 959. The main attention is directed, however, to the handling of different frequency characteristics.

Since the number of circuits on a chip has increased and the number of chips mounted on a module has increased in response to the demand for increased performance of large-scale computers, the number of required pins on the module has also increased, these pins including signal pins to provide the necessary information signals to the chips and power distribution pins to provide the necessary voltage and current to power the chips. Since the number of required pins has increased, the number of power distribution planes in the printed circuit board has also increased. Therefore, the thickness of the board has increased. As a result of the increased board thickness, greater power losses are experienced. Board manufacturing complexity also increases as board thickness increases.

Furthermore, due to the increased number of pins, the module must be larger to accommodate the required number of pins. However, the trend, in the design of a computer system, is toward miniaturization of computer system components, not toward enlarging the size of these components.

Therefore, the prior art packaging system could not meet the demand for an increased number of circuits and a resultant increase in the number of integrated circuit chips mounted on a module and, simultaneously, minimize its power losses as well as meet the demand for the miniaturization of computer system components. Another packaging system design is needed to achieve simultaneously the following desired objectives, that is, to increase the performance associated with a computer system, to minimize the power losses associated with the computer system components, and to maintain the trend toward the miniaturization of the computer system components.

### Summary of the Invention

Accordingly, it is a primary object of the present invention to provide another printed circuit board packaging system design capable of achieving the above mentioned desired objectives.

It is another object of the present invention to provide another printed circuit board packaging system design involving a direct module powering approach for powering the integrated circuit chips on a module whereby the module is powered directly from the power distribution bus rather than from the bus via the power distribution planes within the board and the input/output pins mounted on the bottom of the module substrate.

These and other objects of the present invention, as claimed, are fulfilled by utilizing a direct module powering approach for powering the integrated circuit chips mounted on a module connected to a printed circuit board. The substrate of the module includes a plurality of voltage distribution planes extending longitudinally and transversely through the substrate, the planes being connected to one or more voltage tabs mounted on the edge of the module substrate. The voltage tabs are connected directly to a power distribution bus. Input/output signal pins are disposed on the bottom surface of the module substrate for the conduction of a required signal to the module integrated circuit chips. Input/output power distribution pins are not needed on the bottom surface of the module substrate for powering the chips. One or more voltage distribution stripes can be disposed on the bottom surface of the module substrate, supplementing the voltage distribution planes internal to the module, for powering a remotely-located chip. Consequently, in spite of the increased number of circuits on a chip, and the increased number of chips needed for the required high performance of the computer system, fewer pins are needed on the bottom surface of the module substrate than was previously required. The power losses associated with the powering of the chips on the module are kept at a minimum and the small size of the module is maintained.

In addition, since there is an increasing need for more signal pins on modules to conduct desired voltage signals to the module chips, and since power distribution pins are no longer needed by the modules, more signal pins may be disposed on the bottom surface of the module for the conduction of required voltage signals to or from the module chips.

## Brief Description of the Drawings

A full understanding of the present invention will be obtained from a reading of the detailed description given hereinbelow and the accompanying drawings, wherein:

FIG. 1 illustrates a conventional thermal conduction module including a plurality of integrated circuit chips disposed thereon, and including a multitude of input/output pins disposed on its bottom surface;

FIG. 2 illustrates a cross sectional view of a prior art package voltage distribution system;

FIG. 3 illustrates the thermal conduction module of FIG. 1 including a plurality of voltage distribution tabs connected to the edge of the module substrate for conducting a voltage and current to the integrated circuit chips mounted thereon as needed to power the chips;

FIG. 4 illustrates a cross sectional view of a printed circuit board and a module mounted thereon, and, in particular, illustrates the direct module powering concept of the present invention;

FIG. 5a illustrates a perspective view of a plurality of voltage distribution planes disposed within the module illustrated in FIG. 4;

FIGS. 5b and 5c illustrate a bottom view of the voltage distribution layer 10c and the voltage reference layer 10d taken along section lines A-A and B-B shown in FIG. 4;

FIG. 6 illustrates a perspective view of the bottom surface of a typical module depicting a multitude of signal pins and a plurality of voltage distribution stripes, each stripe transmitting a voltage from a voltage distribution plane by way of a plated via to an integrated circuit chip by way of another plated via;

FIGS. 7a and 7b illustrate the functional operation of one embodiment of the present invention; and

FIGS. 7c and 7d illustrate the functinal operation of another embodiment of the present invention.

## Detailed Description of the Preferred Embodiment

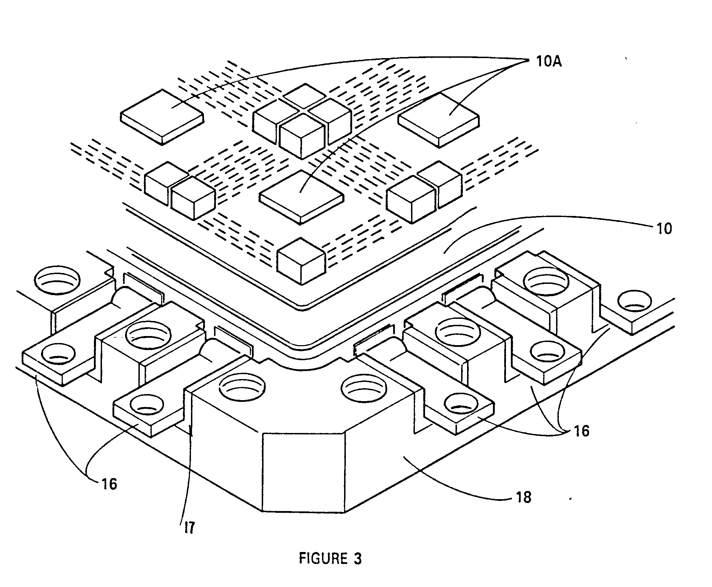

Referring to FIG. 3, a perspective view of a module 10 is illustrated. In contrast with FIG. 1, and according to the present invention, a plurality of voltage distribution tabs 16 are connected to the edge of the module substrate for conducting a voltage and a current to the integrated circuit chips 10a disposed on the module 10. The voltage and the current are needed to power the chips. Each of the tabs 16 connects to a base plate 18 via an insulating material 17.

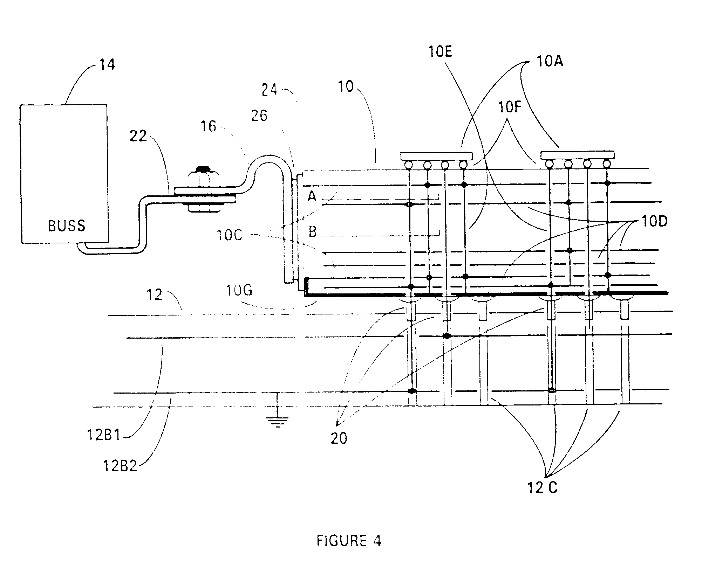

Referring to FIG. 4, the direct module powering concept according to the present invention is illustrated. In FIG. 4, a printed circuit board 12 is illustrated. A module 10 is mounted on the board 12 and is connected thereto via a plurality of signal distribution input/output (I/O) pins 20. A voltage tab 16 is shown connected to the edge of the substrate of module 10. The voltage tab 16 is connected directly to a power distribution bus 14 via a power feed tab 22. The module 10 includes a plurality of voltage distribution planes 10c extending longitudinally and transversely through the module, each plane being substantially parallel to each other plane within the module. The voltage tabs 16 are connected to the edges of one or more of the voltage distribution planes 10c via a metallic interface 24 and a brazing compound 26 disposed between the metallic interface 24 and the voltage tab 16. The tab 16 comprises a copper-carbon composite or other suitable material with compatible physical and electrical properties. The module 10 also includes one or more voltage reference (or ground) planes 10d extending longitudinally and transversely through the module, each of the voltage reference planes being substantially parallel to each of the other planes within the module. A plurality of plated vias 10e extend orthogonally through the module 10, the vias being an electrical conducting material, such as copper. The electrical conducting material associated with each via 10e electrically connects the selected voltage distribution planes 10c to chips 10a and connects the selected voltage reference planes 10d to chips 10a thereby providing an electrical conducting path between the voltage distribution plane 10c, the chips 10a, and the voltage reference plane 10d. A plurality of voltage distribution stripes 10g are disposed on the bottom surface of the module 10 and are connected to selected plated vias 10e for providing an alternate path for the required voltage and current from voltage tab 16 necessary to power the chips 10a disposed on the module 10. Alternatively, tab 16 may be directly connected to stripes 10g in order to provide an additional conduction path.

For example, in order to power a remotely-located chip 10a on the module 10 using the voltage distribution stripe 10g, the current is conducted along a path consisting of a voltage tab 16, the brazing compound 26, the metallic interface 24, a voltage distribution plane 10c, a plated via 10e, a voltage stripe 10g, another plated via 10e, and the remotely-located chip 10a. A plurality of integrated circuit chips 10a are connected to the plated vias 10e via solder balls 10f for providing the electrical communication path between the chips 10a and the vias 10e.

In order to power a chip 10a on the module 10 without using the voltage distribution stripe 10g, a voltage tab 16 is connected to the chip 10a via the brazing compound 26, the metallic interface 24, the voltage distribution plane 10c, the plated via 10e, and the solder ball. To provide a return path for current to a ground connection, the chip 10a is connected to another voltage tab 16 via a solder ball 10f, a plated via 10e, the voltage reference (ground) plane 10d, a metallic interface 24, and the brazing compound 26.

In FIG. 4, the printed circuit board 12 includes a plurality of voltage planes 12b. These planes 12b include voltage and current signal planes, such as plane 12b1, connected to a source of signal current and at least one ground plane, such as plane 12b2, connected to a ground potential. The signal planes are used to carry the signal current to the integrated circuit chips 10a via the pins 20 and the ground plane is used to carry the return signal current from the chips to ground via pins 20. The board 12 includes a plurality of plated vias 12c. When the module 10 is mounted on the board 12, the pins 20 are disposed within the plated vias 12c. The vias 12c provide an electrical communication path between the pins 20 and the voltage planes 12b.

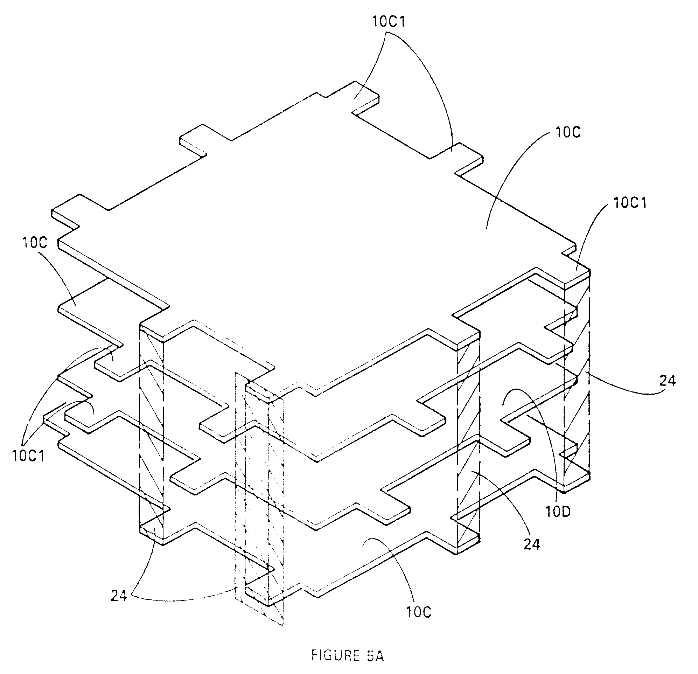

Referring to FIG. 5a, a perspective view of a plurality of voltage distribution planes 10c and at least one voltage reference plane 10d is illustrated. In FIG. 5a, each of the planes 10c and 10d include a plurality of extended tabs 10c1 disposed on each of the four sides thereof for communicating electrically with a voltage tab 16. Each extended tab 10c1 is in contact with a metallic interface 24 of FIG. 4. As shown in FIG. 4, the metallic interface 24 is connected to a voltage tab 16 via the brazing compound 26. The voltage tab 16 is exposed to a particular voltage potential for energizing the integrated circuit chips disposed on the module 10. As shown in FIG. 5a, the metallic interface 24 may be diposed in contact with two of the extended tabs 10c1. In this way, the voltage planes 10c, having the extended tabs 10c1 in contact with the metallic interface 24, will each be exposed to the same voltage potential as carried by the voltage tab 16 connected thereto.

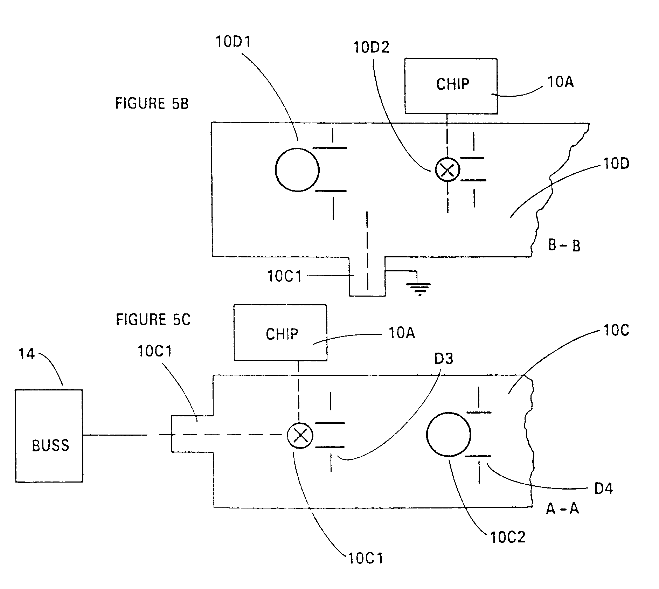

Referring to FIGS. 5b and 5c, a bottom view of the voltage distribution metallization layer 10c and the voltage reference metallization layer 10d, taken along section lines A-A and B-B shown in FIG. 4, is illustrated. In FIG. 5b, a bottom view of the voltage reference layer 10d is shown, the layer including a through hole 10d1 and a through hole 10d2. Through hole 10d1 has a diameter d1 whereas through hole 10d2 has a diameter d2. In FIG. 5b, diameter d1 is greater than diameter d2. Diameter d2 is smaller since electrical contact must be made with a metallic plating in its via 10e in order to provide a return path for current from chip 10a. The current returns to ground potential via extended tab 10c1. In FIG. 5c, a bottom view of the voltage distribution layer 10c is shown, the layer including a through hole 10c1 and a through hole 10c2. Through hole 10c1 has a diameter d3 whereas through hole 10c2 has a diameter d4. In FIG. 5c, diameter d4 is greater than diameter d3. Diameter d3 is smaller since electrical contact must be made with a metallic plating in its via 10e in order to provide a path for current from the power distribution bus 14 to chip 10a. Since diameters d1 and d4 are larger than diameters d2 and d3, respectively, no such electrical contact is made between the metallization layers associated with through holes 10d1 and 10c2 and the metallic plating in their vias 10e.

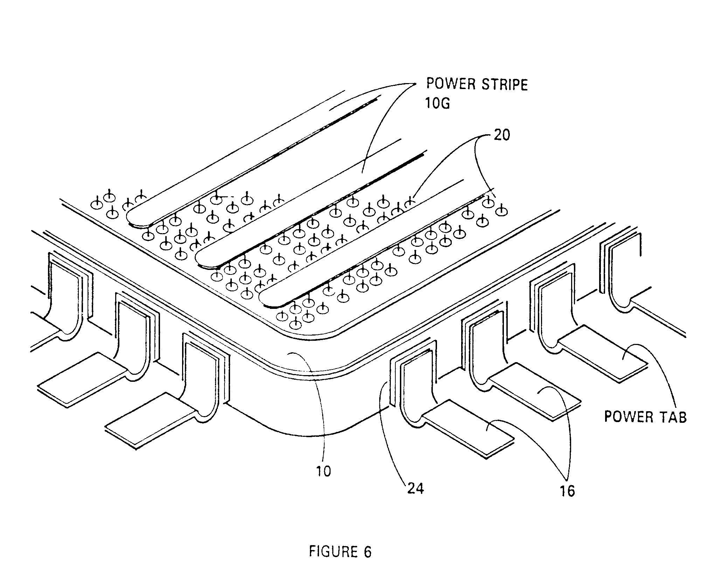

Referring to FIG. 6, a perspective view of the bottom surface of module 10 is illustrated. In FIG. 6, the bottom surface of module 10 includes a multitude of input/output signal pins 20. These pins carry the necessary signal current to the chips 10a, and are not used to power the chips 10a. The pins 20 are arranged in groups. A voltage distribution stripe 10g is disposed between adjacent groups of the pins 20 for the purpose of powering remotely-located chips 10a relative to the voltage tab 16 exposed to the voltage from the power source 14. For example, the current necessary to power a remotely-located chip 10a traverses a path consisting of the voltage tab 16, brazing compound 26, metallic interface 24, the extended tab 10c1 of a voltage distribution plane 10c, a plated via 10e, a voltage distribution stripe 10g, another plated via 10e, and the solder ball 10f of the remotely-located chip 10a.

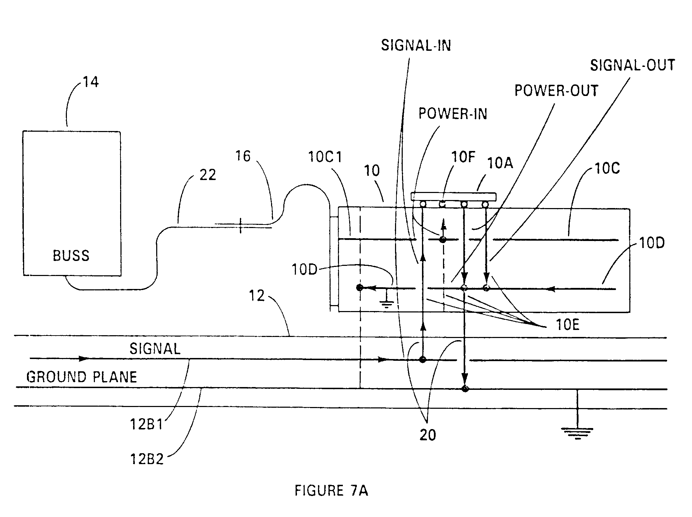

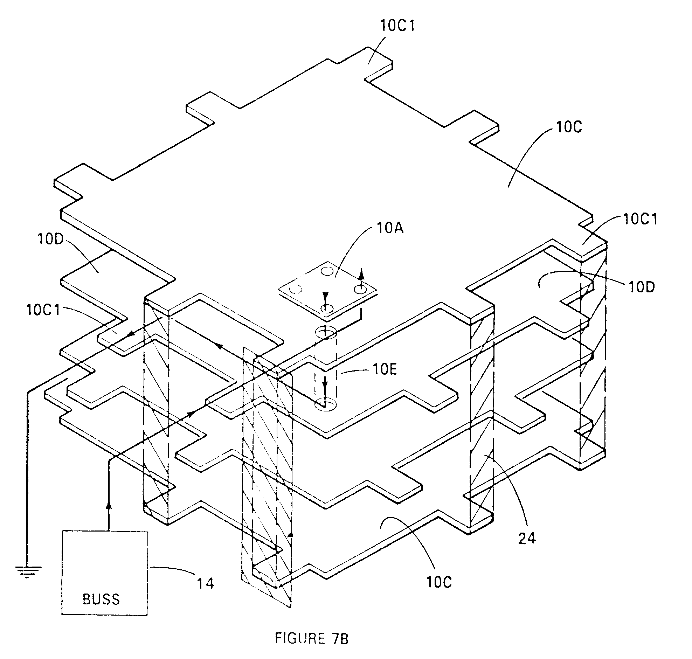

The functional operation of the present invention will be described in the paragraphs below with reference to FIGS. 7a through 7d. In FIGS. 7a and 7b, the functional operation of one embodiment of the present invention is illustrated. In FIG. 7a, module 10 is powered directly from bus 14 via voltage tab 16. The required voltage and current, needed to power the chips 10a on the module 10, traverses a path indicated in the drawing by voltage tab 16, voltage distribution layer 10c and plated via 10e. This path is annotated in the drawing by the label "power-in". The return path for the required current, to ground potential, is annotated in the drawing by the label "power-out", the return current traversing a path indicated by plated via 10e, and voltage reference layer 10d. The reference layer is connected to another tab 16 connected to ground potential. The voltage reference layer 10d is maintained at ground potential by virtue of its connection to ground plane 12b2 in the printed circuit board 12. The required signal current is provided via signal plane 12b1, the signal current provided to module 10 via a path indicated by signal plane 12b1, pin 20, plated via 10e, and solder ball 10f. The required signal current is annotated in the drawing by the label "signal-in". The signal current returns to ground potential by way of solder ball 10f, plated via 10e and voltage reference layer 10d. The return signal current is annotated in the drawing by the label "signal-out". FIG. 7b illustrates this functional operation, of this one embodiment of the present invention, in three dimensions.

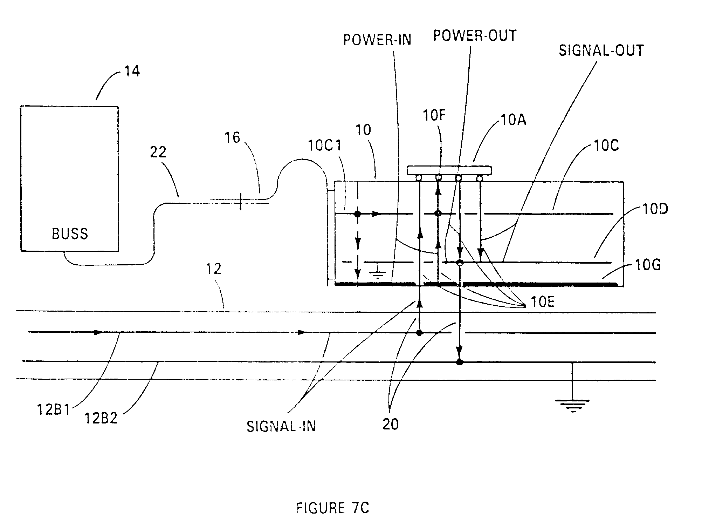

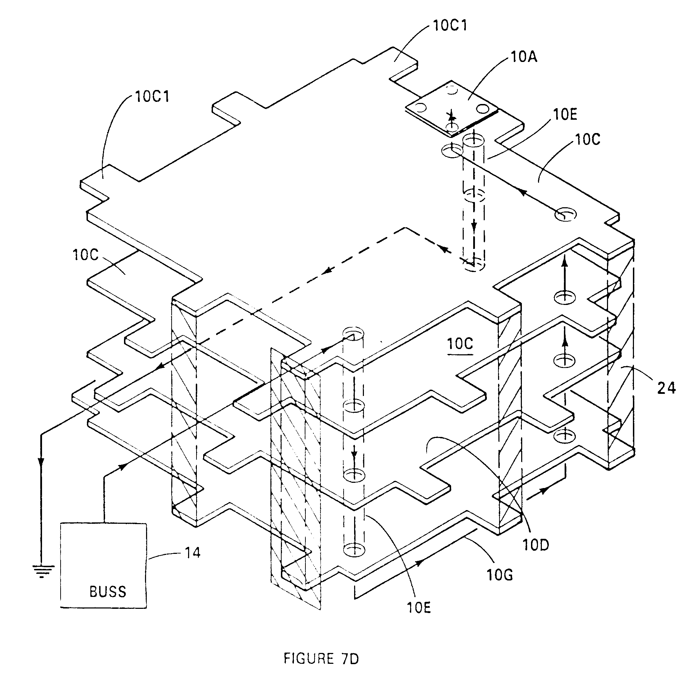

In FIGS. 7c and 7d, the functional operation of another embodiment of the present invention is illustrated. In FIG. 7c, module 10 is powered directly from bus 14 via voltage tab 16. The current required to power the chips 10a on module 10 traverses a path indicated by tab 16, extended tab 10c1 of voltage distribution layer 10c, plated via 10e, voltage distribution stripe 10g, another plated via 10e, and solder ball 10f. This required current is annotated in the drawing by the label "power-in". The current returns to ground potential by way of plated via 10e, voltage reference layer 10d, another extended tab 10c1, and another voltage tab 16. The return current is annotated in the drawing by the label "power-out". The voltage reference layer 10d is maintained at ground potential by virtue of ground plane 12b2 in the printed circuit board 12. The signal current required by the chip 10a on the module 10 is provided by signal plane 12b1 in board 12, the signal current traversing a path to module 10 indicated by signal plane 12b1 and plated via 10e. The required signal current is annotated in the drawing by the label "signal-in". The return path for the signal current is provided by plated via 10e, voltage reference layer 10d, another extended tab 10c1 of voltage reference layer 10d, and another voltage tab 16. The return signal current is annotated in the drawing by the label "signal-out". FIG. 7d illustrates this functional operation, of another embodiment of the present invention, in three dimensions.

## Claims

1. A system for powering an integrated circuit chip (10a) disposed on a module (10), including a printed circuit board (12), a power bus means (14) external to said printed circuit board for providing a supply of power, and said module mounted on and substantially coplanar with said printed circuit board, characterized by:

   voltage tab means (16) connected to the periphery of said module (10) for supplying power directly to said module when power is supplied from said power bus to said tab means; and

   connection means (22) interconnected between said tab means and said power bus means for supplying power from the power bus means directly to said module via said tab means without passing by way of said printed circuit board.

2. An electronic module, comprising:

   a substrate (10);

   at least one integrated circuit chip (10a) mounted on said substrate;

a plurality of metallization layers (10c, d) disposed longitudinally and transversely within said substrate, each of the layers being approximately parallel to one another;

a plurality of plated vias (10e) disposed orthogonally with respect to said metallization layers, at least two plated vias electrically connecting said integrated circuit chip to two corresponding metallization layers; and characterized by:

plural tab means (16) mounted on the peripheral edge of said substrate (10) and electrically connected (26, 24) to the edge (10c1) of said two corresponding metallization layers for conducting a current and a voltage directly from a power source to said integrated circuit chip and for conducting a return current from the integrated circuit chip to a ground potential.

3. An electronic module in accordance with claim 2 further comprising:

at least two additional plated vias (10e) electrically connected on one end to said integrated circuit chip; and

power distribution stripe means (10g) disposed on the bottom surface of said substrate (10), connected to the other end of said two additional plated vias, and connected to said tab means (16) for conducting a current from said tab means to said integrated circuit chip by way of one of said additional plated vias and for conducting a return current from said integrated circuit chip to said ground potential by way of another of said additional plated vias.

4. A method of powering an electronic module (10) mounted on a printed circuit board (12), said module being supplied with power from a power distribution bus (14), characterized by the step of:

connecting (22, 16, 26, 24) said module directly to said power distribution bus, said module being devoid of any connection to said bus by way of said printed circuit board.

**Revendications**

1. Système pour alimenter une microplaquette de circuits intégrés (10a) disposée sur un module (10) comportant une carte de circuits imprimés (12), un moyen de bus d'énergie (14) externe à ladite carte de circuits imprimés pour fournir une alimentation de puissance, et ledit module monté sur et pratiquement coplanaire avec ladite carte de circuits imprimés, caractérisé par :

des moyens de languette de tension (16) connectés a la périphérie dudit module (10) pour alimenter directement ledit module lorsque l'énergie est délivrée depuis ledit bus d'énergie vers lesdits moyens de languette ; et

des moyens de connexion (22) interconnectés entre lesdits moyens de languette et ledit moyen de bus d'énergie pour délivrer l'énergie depuis le moyen de bus d'énergie directement audit module par l'intermédiaire desdits moyens de languette sans passer par ladite carte de circuits imprimés.

2. Module électronique comprenant :

un substrat (10) ;

au moins une microplaquette de circuits intégrés (10a) montée sur ledit substrat ;

une pluralité de couches de métallisation (10c, d) disposées longitudinalement et transversalement à l'intérieur dudit substrat, chacune des couches étant approximativement parallèle à chacune des autres ;

une pluralité de trous d'interconnexion métallisés (10e) disposés orthogonalement par rapport auxdites couches de métallisation, au moins deux trous d'interconnexion métallisés connectant électriquement ladite microplaquette de circuits intégrés à deux couches de métallisation correspondantes ; et caractérisé par :

des moyens de languette multiple (16) montés sur le bord périphérique dudit substrat (10) et électriquement connectés (26, 24) au bord (10c1) desdites deux couches de métallisation correspondantes pour conduire un courant et une tension directement depuis une source d'énergie vers ladite microplaquette de circuits intégrés et pour conduire un courant de retour depuis la microplaquette de circuits intégrés vers un potentiel de masse.

3. Module électronique selon la revendication 2 comprenant de plus :

au moins deux trous d'interconnexion métallisés supplémentaires (10e) électriquement connectés sur une extrémité à ladite microplaquette de circuits intégrés ; et

des moyens de bande de distribution d'énergie (10g) disposés sur la surface de fond dudit substrat (10), connectés à l'autre extrémité desdits deux trous d'interconnexion métallisés supplémentaires, et connectés audit moyen de languette (16) pour conduire un courant depuis ledit moyen de languette vers ladite microplaquette de circuits intégrés à l'aide d'un trou d'interconnexion métallisé desdits trous d'interconnexion métallisés supplémentaires et pour conduire un courant de retour depuis la microplaquette de circuits intégrés vers ledit potentiel de masse à l'aide d'un autre trou d'interconnexion métallisé desdits trous d'interconnexion métallisés supplémentaires.

4. Procédé pour alimenter un module électronique (10) monté sur une carte de circuits imprimés (12), ledit module étant alimenté avec de l'énergie depuis un bus de distribution d'énergie (14), caractérisé par l'opération consistant à :

connecter (22, 16, 26, 24) ledit module directement audit bus de distribution d'énergie, ledit module étant dépourvu de toute connexion quelconque audit bus par l'intermédiaire de ladite carte de circuits imprimés.

**Patentansprüche**

1. System zur Stromversorgung eines auf einem Modul (10) angeordneten integrierten Schaltkreischip (10a), mit einer gedruckten Schaltkarte (12), mit einem Versorgungs-Bus (14) zur Stromversorgung, wobei der Versorgungs-Bus von der gedruckten Schaltkarte getrennt ist und wobei das Modul auf der gedruckten Schaltkarte angeordnet ist und im wesentlichen koplanar zu der gedruckten Schaltkarte ist,

**gekennzeichnet dadurch, daß**

Kontaktmittel (16) mit der Peripherie des Moduls (10) verbunden sind, so daß bei Leistungsübertragung von dem Versorgungs-Bus zu den Kontaktmitteln der Strom direkt in das Modul fließt,

und daß Verbindungsmittel (22) zwischen die Kontaktmittel und den Versorgungs-Bus geschaltet sind, so daß der Strom zur Stromversorgung von dem Versorgungs-Bus über die Kontaktmittel direkt zu dem Modul fließt, ohne über die gedruckte Schaltung zu fließen.

2. Elektronisches Modul mit

einem Substrat (10),

mit wenigstens einem auf dem Substrat (10) angeordneten integrierten Schaltkreischip (10a),

mit mehreren sich in longitudinaler und transversaler Richtung in dem Substrat erstreckenden aufmetallisierten Schichten (10c, d), wobei die Schichten ungefähr parallel zueinander sind,

mit bezüglich den aufmetallisierten Schichten rechtwinklig angeordneten plattierten Durchgangsleitungen (10e), wobei wenigstens zwei der besagten plattierten Durchgangsleitungen den integrierten Schaltkreischip mit zwei entsprechenden aufmetallisierten Schichten elektrisch verbinden,

**gekennzeichnet dadurch, daß**

mehrere Kontaktmittel (16) an der äußeren Begrenzung des Substrats (10) angeordnet sind und elektrisch mit einer Kante (10c1) der beiden entsprechenden aufmetallisierten Schichten verbunden sind (26, 24), um Strom und Spannung direkt von einer Leistungsquelle zu dem integrierten Schaltkreischip zuzuführen und um Rückstrom von dem integrierten Schaltkreischip zu Massepotential zurückzuleiten.

3. Elektronisches Modul nach Anspruch 2,

**weiterhin enthaltend**

wenigstens zwei weitere plattierte Durchgangsleitungen (10e), die an einem Ende elektrisch mit dem integrierten Schaltkreischip verbunden sind, und

streifenförmige Mittel (10g) zur Leistungsverteilung, die an der Bodenfläche des Substrats (10) angeordnet und zur Leistungsverteilung mit dem anderen Ende der zwei weiteren plattierten Durchgangsleitungen und mit den Kontaktmitteln (16) verbunden sind, so daß ein Strom von den Kontaktmitteln zu dem integrierten Schaltkreischip durch eine der weiteren plattierten Durchgangsleitungen fließt und ein Strom von dem integrierten Schaltkreischip zu Massepotential durch eine andere der besagten weiteren plattierten Durchgangsleitungen zurückfließt.

4. Verfahren zur Stromversorgung eines auf einer gedruckten Schaltkarte (12) angeordneten elektronischen Moduls (10), wobei dem elektronischen Modul Strom über einen Versorgungs-Bus (14) zugeführt wird,

**gekennzeichnet durch die Schritte, daß**

das Modul derart direkt mit dem Versorgungs-Bus verbunden wird (22, 16, 26, 24), daß das besagte Modul nicht über die besagte gedruckte Schaltkarte mit dem Versorgungs-Bus verbunden wird.

CHIP

10A

10

PINS
10B

FIGURE 1

FIGURE 2

FIGURE 3

FIGURE 4

FIGURE 5A

FIGURE 5B

FIGURE 5C

POWER STRIPE
10G

20

POWER TAB

10

24

16

FIGURE 6

FIGURE 7A

FIGURE 7B

17

FIGURE 7C

FIGURE 7D